# EUROPEAN PATENT APPLICATION

(11) **EP 4 700 465 A1**
(43) Date of publication of application: **25.02.2026**
(21) Application number: 25192539.2
(22) Date of filing: 29.07.2025
(51) Int. Cl.: G02F 1/1345, G02F 1/1362, H05K 1/02, G02F 1/13

(54) **DISPLAY DEVICE AND ELECTRONIC DEVICE INCLUDING THE SAME**

(30) Priority: 22.08.2024 KR 20240112862
(71) Applicant: Samsung Display Co., Ltd., Yongin-si, Gyeonggi-do 17113 (KR)
(72) Inventor: CHO, Young Min, 17113 Yongin-si (KR); MIN, Jin Sic, 17113 Yongin-si (KR); YEO, Sang Won, 17113 Yongin-si (KR); LEE, Chang Jin, 17113 Yongin-si (KR)
(74) Representative: Walaski, Jan Filip

(57) **Abstract**

A display device includes a display panel including a non-bonding area formed at an end portion thereof and defining first and second sides of the end portion the display panel; a first substrate having a notch formed therein to correspond to the non-bonding area, and includes a driving element for driving the display panel; and a second substrate connected with a second end portion of the first substrate, wherein the display panel includes a first-1 test pad at the first side of the panel, the first substrate includes a first-1 connection pad bonded with the first-1 test pad, a second-1 connection pad connected with the first-1 connection pad through first lines, the second substrate includes a second-1 test pad bonded with the second-1 connection pad, and a first test point connected with the second-1 test pad, and a portion of the first lines overlap the driving element.

## Description

### CROSS-REFERENCE TO RELATED APPLICATION

**This** application claims priority to Korean Patent Application No. 10-2024-0112862, filed on 22 August 2024 in the Korean Intellectual Property Office.

### BACKGROUND

### 1. Technical Field

**The** present disclosure relates to a display device and an electronic device including the display device.

### 2. Discussion of Related Art

As information-based societies have developed, various demands have emerged for display devices capable of displaying images. Accordingly, various types of display devices have been developed, such as liquid crystal displays (LCD), plasma display panels (PDP), and organic light-emitting displays (OLED).

Typically, a display device may include a display panel and a driving element (e.g., a display driver integrated-circuit (DDI)) for controlling driving of the display panel. The driving element may be mounted on a chip on film (COF), which may be bonded (e.g., compression bonded) to an end portion of the display panel. The chip on film may be bonded to the display panel through an adhesive resin (e.g., an anisotropic conductive film (ACF)). Specifically, an adhesive resin containing a plurality of conductive particles may be applied to an end portion of the display panel, and the chip on film may be positioned on the end portion of the display panel to which the adhesive resin is applied. The chip on film and the display panel may be compressed together, and the display panel and the chip on film may be electrically connected by the conductive particles contained in the adhesive resin.

A bonding resistance between the display panel and the chip on film may affect the performance of the display device. Bonding resistance may be understood as the electrical resistance encountered at junctions where different conductive materials are bonded together, which can impact the effectiveness of grounding and bonding systems. For example, if the bonding resistance is increased to a reference value or higher, performance of the display device may be negatively affected. Therefore, the display device may include a test pad and a test point (TP) for measuring the bonding resistance at end portions (hereinafter, "bonded portion") where the display panel and the chip on film are bonded.

### SUMMARY

According to an aspect of various embodiments of the present disclosure, there is provided a display device which may inspect and/or monitor a bonding quality between a chip on film having a notch structure and a display panel, and an electronic device including the display device.

Further, another aspect of various embodiments of the present disclosure, there is provided a display device with improved reliability for the display device, and an electronic device including the display device.

Furthermore, another aspect of various embodiments of the present disclosure, there is provided a display device which may improve (or enhance) a manufacturing efficiency of the display device, and an electronic device including the display device.

The problems of the present disclosure are not limited to the technical problem described herein, and other technical problems not described will be clearly understood by those skilled in the art from the following descriptions.

According to an embodiment of the present disclosure, a display device may include: a display panel which includes a non-bonding area formed at an end portion thereof and defining a first side portion and a second side portion of the end portion the display panel; a first substrate which has a first end portion connected with the end portion of the display panel and a notch formed therein to correspond to the non-bonding area, and includes a driving element configured to control driving of the display panel; and a second substrate connected with a second end portion of the first substrate. The display panel may include a first-1 test pad disposed at the first side portion of the display panel and a first-2 test pad disposed at the second side portion of the display panel. The first substrate may include a first-1 connection pad bonded with the first-1 test pad, a first-2 connection pad bonded with the first-2 test pad, a second-1 connection pad connected with the first-1 connection pad through a first line, and a second-2 connection pad connected with the first-2 connection pad through a second line. The second substrate may include a second-1 test pad bonded with the second-1 connection pad, a second-2 test pad bonded with the second-2 connection pad, a first test point connected with the second-1 test pad, and a second test point connected with the second-2 test pad. A portion of the first line and a portion of the second line may be overlapped with the driving element.

According to an embodiment, the non-bonding area may include: an area receiving at least one component mounted on an external device to which the display device is mounted; or an area where a display panel notch is formed so that at least one component mounted on the external device passes therethrough.

According to an embodiment, the display panel may further include a first-3 test pad disposed at the first side portion of the display panel and a first-4 test pad disposed at the second side portion of the display panel, wherein the first side portion and the second side portion are separated by the non-bonding area. The first substrate may further include a first-3 connection pad bonded with the first-3 test pad, a first-4 connection pad bonded with the first-4 test pad, a second-3 connection pad connected with the first-3 connection pad through a third line, and a second-4 connection pad connected with the first-4 connection pad through a fourth line. The second substrate may further include a second-3 test pad bonded with the second-3 connection pad, a second-4 test pad bonded with the second-4 connection pad, a third test point connected with the second-3 test pad, and a fourth test point connected with the second-4 test pad.

According to an embodiment, the first-1 test pad, the first-2 test pad, the first-3 test pad, the first-4 test pad, the first-1 connection pad, the first-2 connection pad, the first-3 connection pad, and the first-4 connection pad may each include four pads, respectively. The second-1 connection pad, the second-2 connection pad, the second-3 connection pad, the second-4 connection pad, the second-1 test pad, the second-2 test pad, the second-3 test pad, and the second-4 test pad may each include five pads, respectively. The first test point, the second test point, the third test point, and the fourth test point may each include six points, respectively.

According to an embodiment, at least one of the display panel and the first substrate may include at least one first alignment mark. At least one of the first substrate and the second substrate may include at least one second alignment mark.

According to an embodiment, the display panel and the first substrate may be bonded in a film on glass (FOG) or film on board (FOB) manner. The driving element may be bonded to the first substrate in a chip on film (COF) manner. The first substrate and the second substrate may be bonded in a film on film (FOF) manner.

According to an embodiment, the first substrate may be formed as a single layer. The second substrate may be formed as a flexible printed circuit board (FPCB).

According to an embodiment, a portion of the first line and a portion of the second line may pass through a lower portion of the driving element.

According to an embodiment, the driving element may include a first-1 driving pad part, a first-2 driving pad part electrically connected with the first-1 driving pad part, a second-1 driving pad part, and a second-2 driving pad part electrically connected with the second-1 driving pad part. The first line may include a first-1 line which connects the first-1 connection pad with the first-1 driving pad part, and a first-2 line which connects the first-2 driving pad part with the second-1 connection pad. The second line may include a second-1 line which connects the first-2 connection pad with the second-1 driving pad part, and a second-2 line which connects the second-2 driving pad part with the second-2 connection pad.

According to an embodiment, the second substrate may further include a fifth test point and a sixth test point which are configured to measure an entire bonding resistance including a first bonding resistance between the display panel and the first substrate, and a second bonding resistance between the first substrate and the second substrate.

According to an embodiment of the present disclosure, an electronic device may include: a housing; and a display device mounted in the housing. The display device may include: a display panel which includes a non-bonding area formed at an end portion thereof and defining a first side portion and a second side portion of the end portion the display panel; a first substrate which has a first end portion connected with the end portion of the display panel and a notch formed therein to correspond to the non-bonding area, and includes a driving element configured to control driving of the display panel; and a second substrate connected with a second end portion of the first substrate. The display panel may include a first-1 test pad disposed at the first side portion of the display panel and a first-2 test pad disposed at the second side portion of the display panel. The first substrate may include a first-1 connection pad bonded with the first-1 test pad, a first-2 connection pad bonded with the first-2 test pad, a second-1 connection pad connected with the first-1 connection pad through a first line, and a second-2 connection pad connected with the first-2 connection pad through a second line. The second substrate may include a second-1 test pad bonded with the second-1 connection pad, a second-2 test pad bonded with the second-2 connection pad, a first test point connected with the second-1 test pad, and a second test point connected with the second-2 test pad. A portion of the first line and a portion of the second line may be overlapped with the driving element.

According to an embodiment of the present disclosure, a display device may include: a display panel which includes a non-bonding area formed at an end portion thereof and defining a first side portion and a second side portion of the end portion of the display panel; a first substrate which has a first end portion connected with the end portion of the display panel and a notch formed therein to correspond to the non-bonding area, and includes a driving element configured to control driving of the display panel; and a second substrate connected with a second end portion of the first substrate. The first substrate may further include a first-1 connection pad bonded with the first-1 test pad, a second-1 connection pad connected with the first-1 connection pad through a first line, a first-3 connection pad bonded with the first-3 test pad, and a second-3 connection pad connected with the first-3 connection pad through a third line. The second substrate may further include a second-1 test pad bonded with the second-1 connection pad, a first test point connected with the second-1 test pad, a second-3 test pad bonded with the second-3 connection pad, and a third test point connected with the second-3 test pad. A portion of the first line may be overlapped with the driving element.

According to an embodiment, the display panel may further include a first-2 test pad and a first-4 test pad disposed at the second side portion of the display panel. The first substrate may further include a first-2 connection pad bonded with the first-2 test pad, a second-2 connection pad connected with the first-2 connection pad through a second line, a first-4 connection pad bonded with the first-4 test pad, and a second-4 connection pad connected with the first-4 connection pad through a fourth line. The second substrate may further include a second-2 test pad bonded with the second-2 connection pad, a second test point connected with the second-2 test pad, a second-4 test pad bonded with the second-4 connection pad, and a fourth test point connected with the second-4 test pad. A portion of the second line may be overlapped with the driving element.

### BRIEF DESCRIPTION OF THE DRAWINGS

**The** above and other objects, features and other advantages of the present disclosure will be more clearly understood from the following detailed description taken in conjunction with the accompanying drawings, in which:
FIG. 1 is a view illustrating a display device;
FIG. 2A is a cross-sectional view taken on line A-A' of FIG. 1;
FIG. 2B is a view illustrating a partial area of a display panel in detail among configurations of a display device;
FIG. 2C is a view illustrating a first substrate in detail among the configurations of the display device;
**FIG.** 2D is a view illustrating a partial area of a second substrate in detail among the configurations of the display device;
FIG. 2E is a view illustrating an example in which the display panel, the first substrate, and the second substrate of the display device are bonded;
**FIG.** 3A is a view illustrating a connection structure which connects a first-1 connection pad with a second-1 connection pad and a first-2 connection pad with a second-2 connection pad;
**FIG.** 3B is a view illustrating a connection structure which connects a first-1 connection pad with a second-1 connection pad and a first-2 connection pad with a second-2 connection pad;
FIG. 4A is a view illustrating an example of inspecting a bonding quality between the display panel and the first substrate;
FIG. 4B is a view illustrating an example of inspecting a bonding quality between the first substrate and the second substrate;
FIG. 5A is a view illustrating a display device;
FIG. 5B is a view illustrating a display device;
FIG. 6 is a view illustrating an electronic device;
FIG. 7A is a cross-sectional view taken on line B-B' when the electronic device of FIG. 6 includes the display device of FIG. 1; and
FIG. 7B is a cross-sectional view taken on line B-B' when the electronic device of FIG. 6 includes the display device of FIG. 5B.

### DETAILED DESCRIPTION

Hereinafter, various embodiments will be described with reference to the accompanying drawings. Specific embodiments will be illustrated in the drawings and described in the following detailed description related thereto, but it is not intended to limit embodiments to a specific form. For example, it is obvious to those skilled art to which the present disclosure pertains that embodiments may be variously modified.

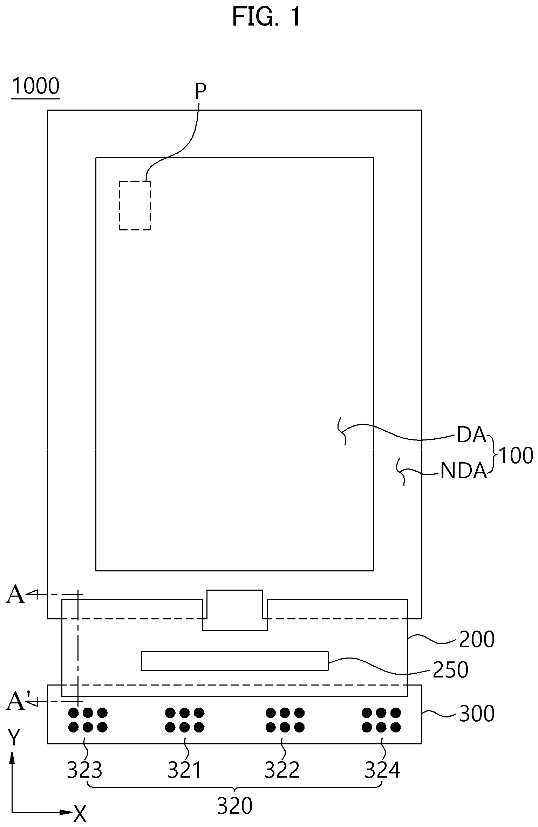

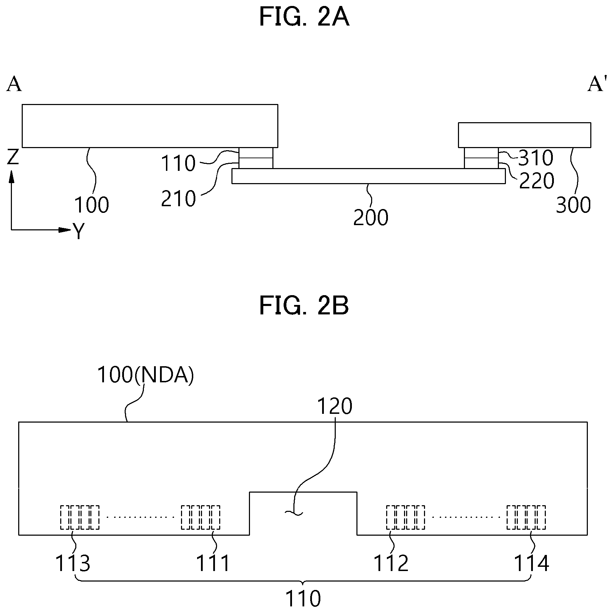

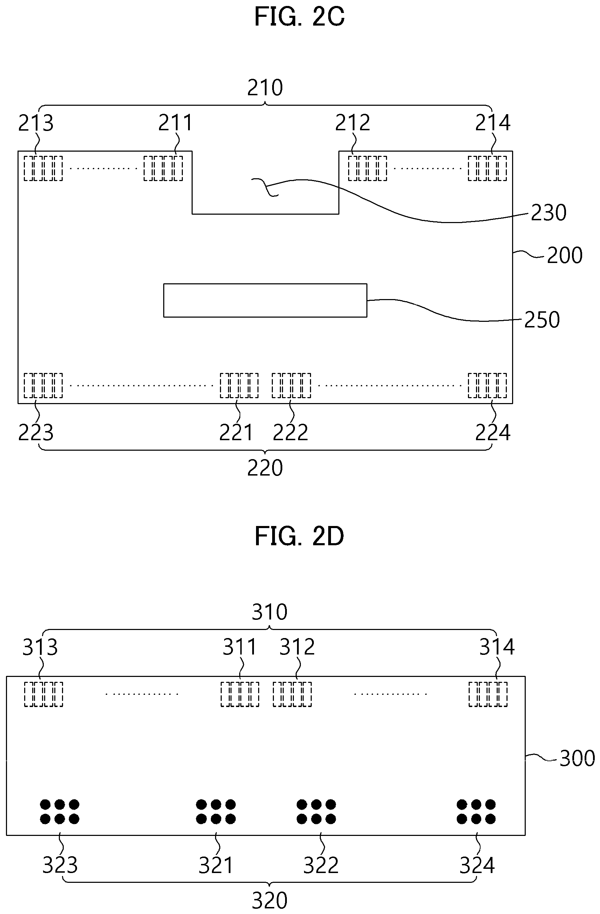

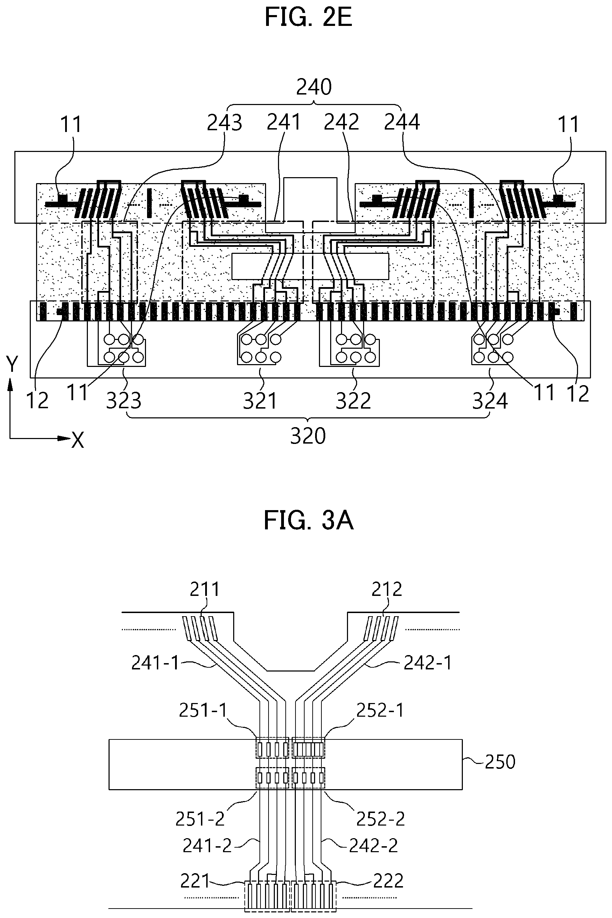

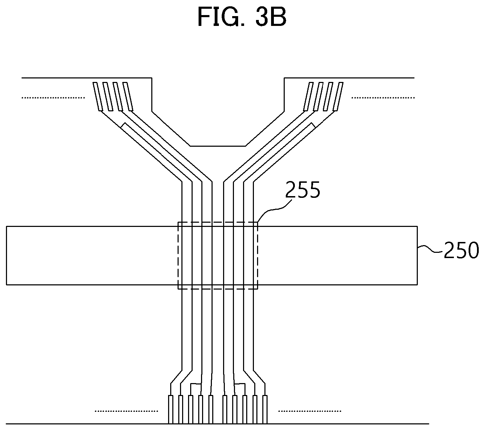

FIG. 1 is a view illustrating a display device. FIG. 2A is a cross-sectional view taken on line A-A' of FIG. 1. FIG. 2B is a view illustrating a partial area of a display panel in detail among configurations of a display device. FIG. 2C is a view illustrating a first substrate in detail among the configurations of the display device. FIG. 2D is a view illustrating a partial area of a second substrate in detail among the configurations of the display device. FIG. 2E is a view illustrating an example in which the display panel, the first substrate, and the second substrate of the display device are bonded. FIG. 3A is a view illustrating a connection structure which connects a first-1 connection pad with a second-1 connection pad and a first-2 connection pad with a second-2 connection pad. FIG. 3B is a view illustrating a connection structure which connects a first-1 connection pad with a second-1 connection pad and a first-2 connection pad with a second-2 connection pad.

A bonding resistance may be measured at one or more test points. The test points may be selected according to an anticipated stress.

A display panel may include a notch structure among areas where a chip on film is bonded. The chip on film bonded to the display panel having the notch structure may also have the notch structure. In the chip on film having the notch structure, significant bending stresses may occur at end portions of the bonded portion and around the notch, such as at side portions of the notch. According to an embodiment, a method for inspecting and/or managing (e.g., monitoring) the bonding resistance around the notch is provided.

Referring to FIGS. 1, 2A to 2B, and 3A to 3B, a display device 1000 according to an embodiment includes a display panel 100, a first substrate 200, and a second substrate 300.

The display panel 100 may output (e.g., display) various images (e.g., still images or moving images). The display panel 100 may be formed of various materials. For example, the display panel 100 may be formed of an inorganic material (e.g., glass) and/or an organic material (such as a metal material, plastic, or resin). The display panel 100 may be formed of a rigid or flexible material. The display panel 100 may be formed to be transparent or opaque.

The display panel 100 may include a display area (DA) and a non-display area (NDA).

The display area DA may display images (e.g., still images or moving images). The display area DA may include a plurality of pixels P and a pixel driving element for driving each pixel. The pixel P may be a unit that displays an image, and may be an organic light emitting element. For example, the pixel P may be a minimum unit that displays an image, and may be an organic light emitting element. This is merely an example, and does not necessarily limit the present disclosure. For example, the pixel P may be a liquid crystal display element or an electrophoretic display element. The pixel driving element may control driving (e.g., light emission) of each pixel. The pixel driving element may include at least one thin film transistor and at least one capacitor, but it is not necessarily limited thereto.

The non-display area NDA may be formed around the display area DA, and the pixels P may not be formed therein. For example, the non-display area NDA may be formed on a lower side, upper side, left side and right side of the display area DA. The non-display area NDA may include various lines (e.g., lines for supplying power and providing image signals to each pixel P, or lines for recognizing touch).

The display panel 100 may include a first notch 120 (e.g., a display panel notch) formed by removing a partial area of the non-display area NDA. Various components (e.g., a charging port or a SIM card slot) on the external device to which the display device 1000 is coupled may be positioned (or located) in the partial area. For example, the components may pass through the display panel 100 through the first notch 120. The partial area, where the first notch 120 is formed, is an area which is not bonded with the first substrate 200, and may be referred to as a non-bonding area. In addition, the display panel 100 may include a panel pad part 110 formed in the non-display area NDA.

The panel pad part 110 may include a plurality of pads for driving the display panel 100 and managing the bonding quality (e.g., bonding resistance) between the display panel 100 and the first substrate 200. For example, as shown in FIG. 2B, the panel pad part 110 may include a first-1 test pad 111, a first-2 test pad 112, a first-3 test pad 113, and a first-4 test pad 114. The first-1 test pad 111 and the first-2 test pad 112 may be inner test pads, and the first-3 test pad 113 and the first-4 test pad 114 may be outer test pads.

As shown in FIG. 2B, the non-bonding area, which may include the first notch 120, may be disposed on an end portion of the display panel 100. The first notch 120 may be disposed at a central portion of the end portion of the display panel 100, but is not necessarily limited thereto. For example, the first notch 120 may be offset to a side of the end portion of the display panel 100.

The first-1 test pad 111 and the first-2 test pad 112 may be formed at positions adjacent to the first notch 120 (e.g., within a designated distance). For example, the first-1 test pad 111 may be formed at a position adjacent to a first side portion (e.g., a left side) of the first notch 120, and the first-2 test pad 112 may be formed at a position adjacent to a second side portion (e.g., a right side) of the first notch 120. For example, the first-1 test pad 111 may be formed at a position adjacent to a first side portion (e.g., a left side) of the first notch 120, with no other pads disposed between the first-1 test pad 111 and the first side portion of the first notch 120, and the first-2 test pad 112 may be formed at a position adjacent to a second side portion (e.g., a right side) of the first notch 120 with no other pads disposed between the first-2 test pad 112 and the second side portion of the first notch 120.

Meanwhile, the first-3 test pad 113 and the first-4 test pad 114 may be formed at positions spaced apart from the first notch 120. The first-3 test pad 113 and the first-4 test pad 114 may be formed at positions spaced apart from the first notch 120 by the designated distance or more. For example, the first-3 test pad 113 may be formed (or positioned) at a first side portion (e.g., the left side) of the display panel 100, and the first-4 test pad 114 may be formed at a second side portion (e.g., the right side) of the display panel 100. The first side portion of the display panel 100 and the second side portion of the display panel 100 may be disposed at the end portion of the display panel 100 and may be separated by the non-bonding area or of the first notch 120.

The first substrate 200 may connect the display panel 100 with the second substrate 300. For example, the first substrate 200 may have a first end portion connected to the display panel 100, and a second end portion connected to the second substrate 300. Specifically, as shown in FIG. 2A, a first-1 substrate pad part 210 of the first substrate 200 and the panel pad part 110 of the display panel 100 may be bonded (e.g., compression bonded using an adhesive resin such as an anisotropic conductive film (ACF)), and a first-2 substrate pad part 220 of the first substrate 200 and a second substrate pad part 310 of the second substrate 300 may be bonded. Meanwhile, in FIG. 2A, it is illustrated that the display panel 100 and the second substrate 300 may be bonded to the same surface (e.g., an upper surface) of the first substrate 200, but the display panel 100 may be bonded to the upper surface (or a lower surface) of the first substrate 200, and the second substrate 300 may be bonded to the lower surface (or the upper surface) of the first substrate 200.

The first substrate 200 may be formed of a flexible material. For example, the first substrate 200 may be a film type flexible printed circuit board (FPCB). The first substrate 200 may be bonded with the display panel 100 in a film on glass (FOG) or film on board (FOB) manner. Meanwhile, the first substrate 200 may be bonded with the second substrate 300 in a film on film (FOF) manner.

The first substrate 200 may be formed as a single layer. In addition, the first substrate 200 may have a second notch 230 formed therein to correspond to the first notch 120. Further, as shown in FIG. 2C, the first substrate 200 may include the first-1 substrate pad part 210, the first-2 substrate pad part 220 and a driving element 250.

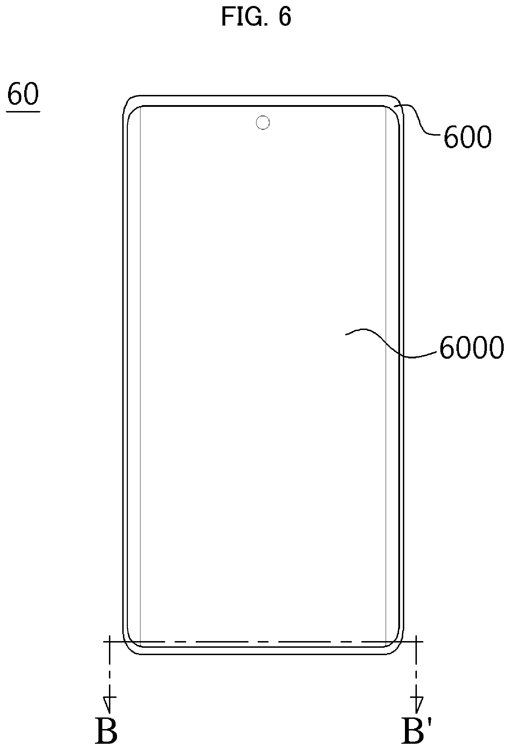

The driving element 250 may control driving of the display panel 100. The driving element 250 may receive various power and driving signals (e.g., an initialization signal, a scan signal, a data signal, or a compensation signal) for controlling driving of the display panel 100 from an external device (e.g., a main board (not shown) of an electronic device 60 shown in FIG. 6), and supply the received power and driving signals to the display panel 100. The driving element 250 may include a display driver integrated-circuit (DDI). The driving element 250 may be bonded to the first substrate 200 in a chip on film (COF) manner. For example, the driving element 250 may be positioned at a central portion of the first substrate 200. For example, the driving element 250 may be positioned at a central portion of the first substrate 200 defined in at least one of the width or the height of the first substrate 200. Here, the height of the first substrate 200 may be determined between a lower end of the second notch 230 and a second end portion of the first substrate 200 to be connected to the second substrate 300. The driving element 250 may be positioned on the first substrate 200 to be aligned with the second notch 230.

As shown in FIG. 2C, the second notch 230 may be disposed on the first end portion of the first substrate 200. The second notch 230 may be disposed at a central portion of the end portion of the first substrate 200, but is not necessarily limited thereto. For example, the second notch 230 may be offset to a side of the end portion of the first substrate 200 to correspond to a position of the first notch 120.

The first-1 substrate pad part 210 may include a plurality of pads for driving of the display panel 100 and managing the bonding quality (e.g., bonding resistance) between the display panel 100 and the first substrate 200. For example, as shown in FIG. 2C, the first-1 substrate pad part 210 may include a first-1 connection pad 211, a first-2 connection pad 212, a first-3 connection pad 213, and a first-4 connection pad 214. The first-1 connection pad 211 and the first-2 connection pad 212 may be first inner connection pads, and the first-3 connection pad 213 and the first-4 connection pad 214 may be first outer connection pads. The first-1 connection pad 211, the first-2 connection pad 212, the first-3 connection pad 213, and the first-4 connection pad 214 may be bonded with the first-1 test pad 111, the first-2 test pad 112, the first-3 test pad 113, and the first-4 test pad 114, respectively. Here, the first-1 connection pad 211, the first-2 connection pad 212, the first-3 connection pad 213, the first-4 connection pad 214, the first-1 test pad 111, the first-2 test pad 112, the first-3 test pad 113, and the first-4 test pad 114 may include four pads, respectively, but they are not necessarily limited thereto.

The first-2 substrate pad part 220 may include a plurality of pads for driving the display panel 100 and managing the bonding quality (e.g., bonding resistance) between the first substrate 200 and the second substrate 300. For example, as shown in FIG. 2C, the first-2 substrate pad part 220 may include a second-1 connection pad 221, a second-2 connection pad 222, a second-3 connection pad 223, and a second-4 connection pad 224. The second-1 connection pad 221 and the second-2 connection pad 222 may be second inner connection pads, and the second-3 connection pad 223 and a second-4 connection pad 224 may be second outer connection pads. As shown in FIG. 2E and 3A, the second-1 connection pad 221, the second-2 connection pad 222, the second-3 connection pad 223, and the second-4 connection pad 224 may be respectively connected with the first-1 connection pad 211, the first-2 connection pad 212, the first-3 connection pad 213, and the first-4 connection pad 214 through a line part 240. For example, the second-1 connection pad 221 may be connected with the first-1 connection pad 211 through first lines 241, the second-2 connection pad 222 may be connected with the first-2 connection pad 212 through second lines 242, the second-3 connection pad 223 may be connected with the first-3 connection pad 213 through third lines 243, and the second-4 connection pad 224 may be connected with the first-4 connection pad 214 through fourth lines 244.

A portion of the first lines 241 and a portion of the second lines 242 may be overlapped with the driving element 250. For example, the first lines 241 and the second lines 242 may be connected with the driving element 250. Specifically, as shown in FIG. 3A, the first-1 connection pad 211 may be connected with a first-1 driving pad part 251-1 through a first-1 line 241-1, and the second-1 connection pad 221 may be connected with a first-2 driving pad part 251-2 through a first-2 line 241-2. At this time, the first-1 driving pad part 251-1 and the first-2 driving pad part 251-2 may be electrically connected inside the driving element 250. Similarly, the first-2 connection pad 212 may be connected with a second-1 driving pad part 252-1 through the second-1 line 242-1, and the second-2 connection pad 222 may be connected with a second-2 driving pad part 252-2 through the second-2 line 242-2. At this time, the second-1 driving pad part 252-1 and the second-2 driving pad part 252-2 may be electrically connected inside the driving element 250.

As another example, the first lines 241 and the second lines 242 may pass through a lower portion of the driving element 250 without being connected with the driving element 250, as shown in FIG. 3B. At this time, the driving element 250 may not have a driving pad formed in an area (hereinafter, "overlapping area") 255 overlapping with the first lines 241 and the second lines 242. The reason is that, due to the single-layer structure of the first substrate 200, when a driving pad exists in the overlapping area 255, it is impossible to prevent a short between the line connected to the corresponding driving pad and the first and second lines 241 and 242.

The second substrate 300 may be formed of a flexible material. For example, the second substrate 300 may be formed as a flexible printed circuit board (FPCB). The second substrate 300 may be connected with the first substrate 200. For example, one end of the second substrate 300 may be connected with the other end of the first substrate 200. Specifically, the second substrate pad part 310 of the second substrate 300 may be bonded with the first-2 substrate pad part 220 of the first substrate 200 in a film on film (FOF) manner.

The second substrate 300 may include the second substrate pad part 310 and a test point part 320.

The second substrate pad part 310 may include a plurality of pads for driving the display panel 100 and managing the bonding quality (e.g., bonding resistance) between the first substrate 200 and the second substrate 300. For example, as shown in FIG. 2D, the second substrate pad part 310 may include a second-1 test pad 311, a second-2 test pad 312, a second-3 test pad 313, and a second-4 test pad 314. The second-1 test pad 311 and the second-2 test pad 312 may be inner test pads, and the second-3 test pad 313 and the second-4 test pad 314 may be outer test pads. The second-1 test pad 311, the second-2 test pad 312, the second-3 test pad 313, and the second-4 test pad 314 may be bonded with the second-1 connection pad 221, the second-2 connection pad 222, the second-3 connection pad 223, and the second-4 connection pad 224, respectively. Here, the second-1 test pad 311, the second-2 test pad 312, the second-3 test pad 313, the second-4 test pad 314, the second-1 connection pad 221, the second-2 connection pad 222, the second-3 connection pad 223, and the second-4 connection pad 224 may include five pads, respectively, but they are not necessarily limited thereto.

The test point part 320 may be formed on the second substrate 300 so as to be exposed to an outside. The test point part 320 may include a first test point 321, a second test point 322, a third test point 323, and a fourth test point 324. The first test point 321 and a second test point 322 may be inner test points, and the third test point 323 and the fourth test point 324 may be outer test points. The first test point 321, the second test point 322, the third test point 323, and the fourth test point 324 may be connected with the second-1 test pad 311, the second-2 test pad 312, the second-3 test pad 313, and the second-4 test pad 314, respectively. Here, the first test point 321, the second test point 322, the third test point 323, and the fourth test point 324 may include six points, respectively, but they are not necessarily limited thereto.

The first test point 321, the second test point 322, the third test point 323, and the fourth test point 324 may be formed on the second substrate 300 so as to be exposed to the outside. This is to allow a measuring member (e.g., a measuring pin) of an external device (not shown) for measuring the bonding resistance to be brought into physical contact with them.

Meanwhile, although not shown in FIGS. 2B to 2D, the display panel 100 and/or the first substrate 200 may include at least one (e.g., four in the case of FIG. 2E) first alignment mark 11 which is to be an alignment reference between the display panel 100 and the first substrate 200. In addition, the first substrate 200 and/or the second substrate 300 may include at least one (e.g., two in the case of FIG. 2E) second alignment mark 12 which is to be an alignment reference between the first substrate 200 and the second substrate 300.

Although not shown in FIG. 1, the display device 1000 may further include a touch electrode part and a touch sensor on the display panel 100.

As described herein, the display device 1000 according to an embodiment may test an inner bonding quality (e.g., bonding resistance) of the second substrate 300, to which the display panel 100 is bonded, through the first-1 test pad 111 and the first-2 test pad 112. In addition, the display device 1000 may test an outer bonding quality of the second substrate 300, through the first-3 test pad 113 and the first-4 test pad 114. In other words, the bonding quality between the first substrate 200 having the notch structure and the display panel 100 may be managed or monitored, thereby improving (or enhancing) the reliability of the display device 1000. In addition, embodiments may provide a display device 1000 with uniform quality.

As shown in FIGS. 2C and 3A, the notch 230 may be disposed in a first end portion of the first substrate 200. Specifically, as shown in FIG. 2C, the second notch 230 may have a rectangular shape, but is not necessarily limited thereto. For example, the second notch 230 may have the shape of one-half of an octagon as shown in FIG. 3A. The second notch 230 may have another shape, such as a semi-circle. Further, the first notch 120 and the second notch 230 may have the same shape or different shapes.

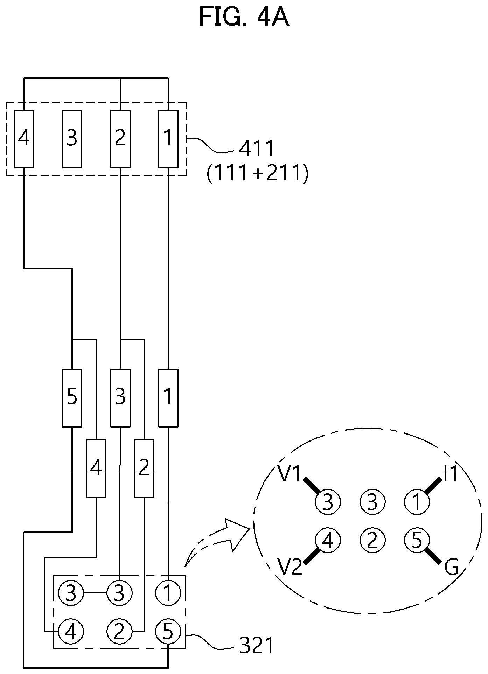

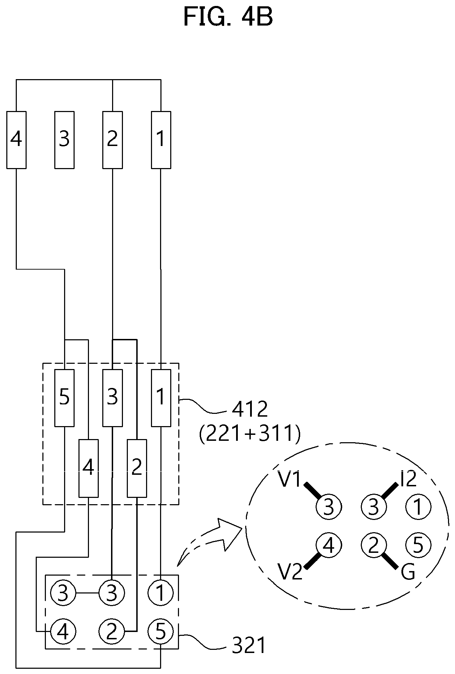

FIG. 4A is a view illustrating an example of inspecting a bonding quality between the display panel and the first substrate, and FIG. 4B is a view illustrating an example of inspecting a bonding quality between the first substrate and the second substrate.

Referring to FIGS. 4A and 4B, the display device 1000 of FIGS. 1, 2A to 2B, and 3A to 3B according to an embodiment may measure a first bonding quality (e.g., a first bonding resistance) between the display panel 100 and the first substrate 200, and a second bonding quality (e.g., a second bonding resistance) between the first substrate 200 and the second substrate 300 through the first test point 321 to the fourth test point 324. For example, the first bonding quality of an area (hereinafter, referred to as a first bonding area) 411 where the first-1 test pad 111 and the first-1 connection pad 211 may be bonded, and the second bonding quality of an area (hereinafter, referred to as a second bonding area) 412 where the second-1 connection pad 221 and the second-1 test pad 311 may be bonded may be measured through the first test point 321. Specifically, as shown in FIG. 4A, an external device (not shown) may apply a designated voltage V1-V2 to a third terminal 3 and a fourth terminal 4 of the first test point 321, measure a current I1 between a first terminal 1 and a fifth terminal 5, and calculate a first bonding resistance of a first bonding area 411 based on the applied voltage V1-V2 and the measured current I1. In addition, as shown in FIG. 4B, the external device (not shown) may apply the designated voltage V1-V2 to the third terminal 3 and the fourth terminal 4, measure a current I2 between the third terminal 3 and a second terminal 2, and then calculate a second bonding resistance of a second bonding area 412 based on the applied voltage V1-V2 and the measured current I2.

Meanwhile, the first bonding quality and the second bonding quality of the corresponding bonding area may be measured through the second test point 322 to the fourth test point 324 shown in FIGS. 1, 2D and 2E may be performed by the same method as described herein with reference to the first test point 321. Therefore, a repeated detailed description a method for measuring the bonding quality through the second test point 322 to the fourth test point 324 may be omitted or simplified.

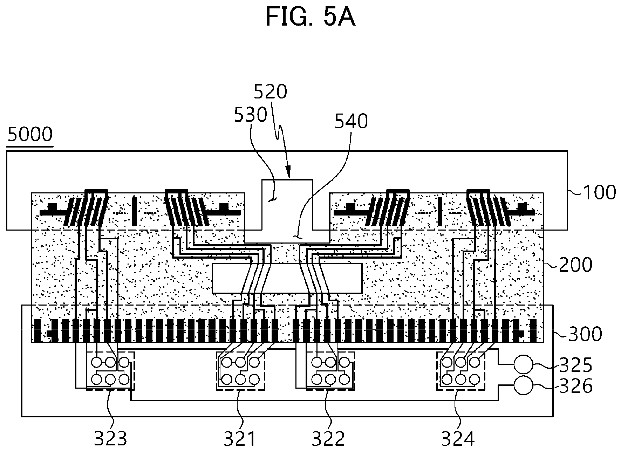

FIG. 5A is a view illustrating another example of a display device.

Referring to FIG. 5A, a display device 5000 may be similar to the display device 1000 of FIG. 1. Accordingly, among the configurations of the display device 5000, configurations similar to those of the display device 1000 are denoted by the same reference numerals and a repeated detailed description thereof may be omitted or simplified.

The display device 5000 may further include a fifth test point 325 and a sixth test point 326 for measuring an entire bonding resistance including the first bonding resistance between the display panel 100 and the first substrate 200 and the second bonding resistance between the first substrate 200 and the second substrate 300. The first test point 321 to the sixth test point 326 may have a loop structure. For example, as shown in FIG. 5A, the fifth test point 325 may be connected with the fourth test point 324, the fourth test point 324 may be connected with the second test point 322, the second test point 322 may be connected with the first test point 321, the first test point 321 may be connected with the fifth test point 325, and the fifth test point 325 may be connected with the sixth test point 326.

The display panel 100 and the first substrate 200 may define an opening 520. The opening 520 may include a first opening portion 530 and a second opening portion 540. The first opening portion 530 may be defined by the first notch 120 and the second opening portion 540 may be defined by the second notch 230. The first notch 120 and the first opening portion 530 may be omitted. A width of the first opening portion 530 and a width of the second opening portion 540 may be the same or different. For example, the width of the second opening portion 540 may be greater than the width of the first opening portion 530. For example, the first substrate 200 may expose a portion of an upper surface of the display panel 100 around the opening 520. That is, widths of the end portions of the first substrate 200 defining the second notch 230 may be fully supported by the display panel 100.

The display device 5000 may check whether there is an abnormality in the bonding quality based on the entire bonding resistance measured through the fifth test point 325 and the sixth test point 326. For example, when the entire bonding resistance is not more than (or less than) a designated reference value, an embodiment of the present disclosure may determine that there is no problem with the bonding between the display panel 100 and the first substrate 200 and/or the bonding between the first substrate 200 and the second substrate 300. On the other hand, when the entire bonding resistance exceeds (or is higher than) the designated reference value, an embodiment of the present disclosure may determine that there is a problem with the bonding between the display panel 100 and the first substrate 200 and/or the bonding between the first substrate 200 and the second substrate 300. At this time, the bonding resistance of each portion may be measured using the first test point 321 to the fourth test point 324, and a location where the problem with the bonding occurs may be identified based on measurement results. In other words, it may be checked/determined whether there is an abnormality in the bonding quality through the entire bonding resistance, and secondarily and precisely detect the location where the problem with the bonding occurred when an abnormality is detected. Through this a manufacturing efficiency of the display device may be improved.

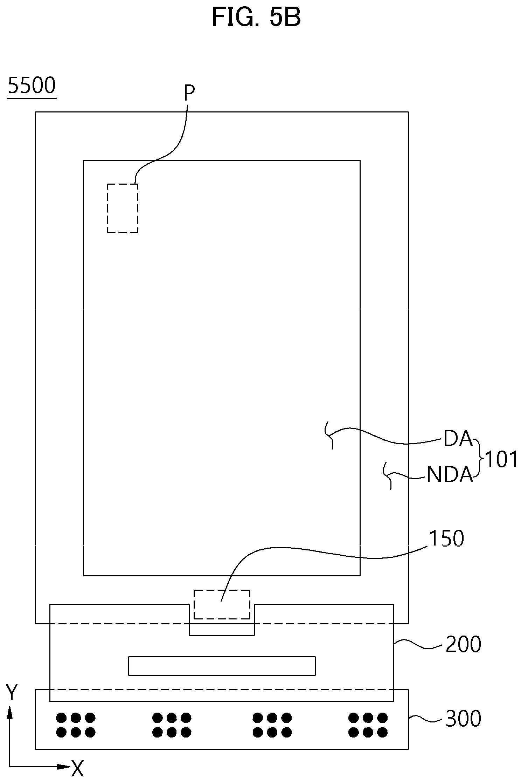

FIG. 5B is a view illustrating another example of a display device.

Referring to FIG. 5B, a display device 5500 may be similar to the display device 1000 of FIG. 1. Accordingly, among the configurations of the display device 5500, configurations similar to those of the display device 1000 are denoted by the same reference numerals and a repeated detailed description thereof may be omitted or simplified.

The display device 5500 is configured in a way that a notch is not formed in a display panel 101, and a partial area of the display panel 101 (e.g., an area where the first notch 120 of the display device 1000 of FIG. 1 is formed) may be set (or designated) as an area (hereinafter, referred to as a non-bonding area) which is not bonded with the first substrate 200. The non-bonding area may include an area receiving at least one component 150 mounted on the external device when bonding the display device 5500 to the external device (e.g., an area where a separation distance between the display panel 101 and the component 150 is not more than (or less than) a thickness of the first substrate 200). The first substrate 200 and the second substrate 300 of FIG. 5B are the same as (or similar to) the first substrate 200 and the second substrate 300 of FIG. 1. In other words, even if the notch does not exist in the display panel 101, the first substrate 200 of 5B may have the second notch 230 (see FIG. 2C) formed therein to avoid (or prevent) interference with the component 150 on the external device.

Meanwhile, the display device 5500 of FIG. 5B may further include a fifth test point and a sixth test point for measuring the entire bonding resistance, like the display device 5000 of FIG. 5A.

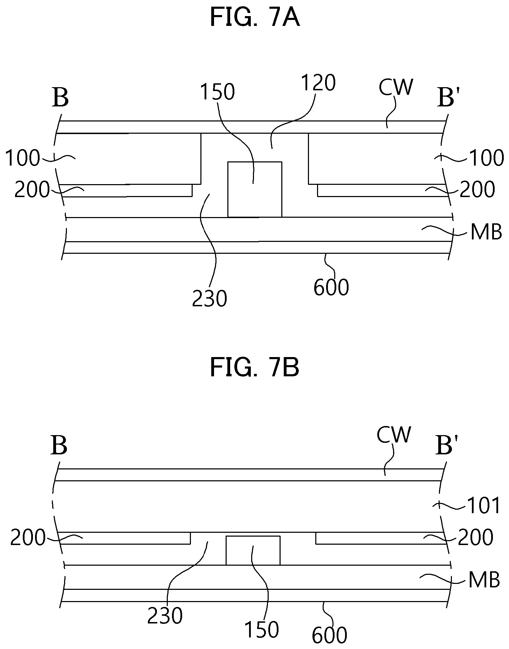

FIG. 6 is a view illustrating an electronic device, FIG. 7A is a cross-sectional view taken on line B-B' when the electronic device of FIG. 6 includes the display device of FIG. 1, and FIG. 7B is a cross-sectional view taken on line B-B' when the electronic device of FIG. 6 includes the display device of FIG. 5B.

Referring to FIGS. 6, and 7A to 7B, an electronic device 60 may include various types of electronic devices. For example, the electronic device 60 may include a rigid type, a flexible type, a foldable type, a rollable type or wearable type portable communication device (e.g., a mobile phone, a smart phone, a smart watch, or a tablet), a computer device (e.g., a laptop or a monitor), a portable multimedia device (e.g., a portable game console), a portable medical device, a photographing device (e.g., a digital camera or a camcorder), a multimedia device installed in, embedded in, or integrally formed with an automobile (e.g., a display for a vehicle, a head-up display), or a home appliance device (e.g., a television). Meanwhile, the electronic device 60 is not necessarily limited to the devices described herein, and may include various types of products (e.g., an augmented reality or virtual reality display, a billboard, or video wall).

The electronic device 60 may include a display device 6000. The display device 6000 may be mounted in a housing 600 of the electronic device 60. For example, the display device 6000 may be mounted in the housing 600 so as to be exposed to an outside through a front surface through a front side of the electronic device 60. The display device 6000 may provide (e.g., display) various images (e.g., still images or moving images).

When the display device 6000 has the same (or similar) structure as the display device 1000 of FIG. 1, the upper surface of the component 150 mounted on the main printed-circuit board (MB) inside the housing 600 may be positioned closely with the lower surface of the cover window (CW) by passing through the first notch 120 of the display panel 100 and the second notch 230 of the first substrate 200, as shown in FIG. 7A. As another example, when the display device 6000 has the same (or similar) structure as the display device 5500 of FIG. 5B, an upper surface of the component 150 mounted on a main circuit board (MB) inside the housing 600 may be positioned closely with a lower surface of the display panel 101 by passing through the second notch 230 of the first substrate 200, as shown in FIG. 7B.

Other configurations of the display device 6000 may be the same as or similar to the display device 1000 of FIG. 1, the display device 5000 of FIG. 5A, or the display device 5500 of FIG. 5B. Therefore, a repeated detailed description of the display device 6000 may be omitted or simplified.

Meanwhile, the display device 6000 may further include a touch panel which supports touch input (e.g., finger touch and pen touch). For example, the display device 6000 may include a touch panel separately or integrally formed therewith.

In addition, the case where the display device 1000 includes one first substrate 200 has been described as an example. However, the display device 1000 may include two or more first substrates 200.

In various examples, the bonding quality between the first substrate (e.g., the chip on film) having a notch structure and the display panel may be inspected (to determine the quality of the display device). In addition, the bonding quality between the first substrate having the notch structure and the display panel may be managed or monitored. For example, the bonding quality may be monitored during bonding. A signal determined using a test point may be used to control an operation of a bonding system compressing the display panel, the first substrate, and the second substrate, for example, to stop a compression given a certain signal sensed at the test point. Through this, various embodiments may improve (or enhance) the reliability of the display device.

In addition, various embodiments may provide a display device with uniform quality. In other words, various embodiments may prevent the provision of a defective display device in which the display panel and the first substrate are not properly bonded.

Further, various embodiments may check whether there is an abnormality in the bonding quality during (or after) the manufacturing of the display device. For example, in various embodiments it may be checked whether there is an abnormality in the bonding quality through the test points added to measure the entire bonding resistance. Through this, various embodiments may improve the manufacturing efficiency of the display device.

The effects according to various embodiments are not necessarily limited to the contents exemplified herein, and more diverse effects may be understood by those skilled in the art from the description stated in the present disclosure.

Embodiments are not to be limited to the technical characteristics described in the present disclosure. Embodiments may be construed to include various modifications, equivalents, or replacements. With regard to the description of the drawings, the same components illustrated in different drawings may be denoted by the same reference numerals. It is to be understood that a singular form of a noun corresponding to an item may include one or a plurality of the things, unless the relevant context clearly indicates otherwise. As used herein, each of phrases such as "A or B," "at least one of A and B," "at least one of A or B," "A, B or C," "at least one of A, B and C," and "at least one of A, B or C" may include any one, or all possible combinations of these items enumerated together in the corresponding one of the phrases. As used herein, the terms such as "1st" and "2nd," or "first" and "second" may be used to simply distinguish the corresponding component from another component, and does not limit the corresponding components in other aspects (e.g., an importance or order). It is to be understood that if a component (e.g., a first component) is referred to as "bonded to" or "connected to" another component (e.g., a second component), with or without the term "operatively" or "communicatively," it means that the component may be bonded to the other component directly (e.g., by wire), wirelessly, or via a third component.

The term "module" used in various embodiments may include a unit implemented in hardware, software or firmware way, and for example, may be used interchangeably with the terms such as logic, a logic block, a part, or a circuit. The module may be a part integrally formed therewith, or a minimum unit of the part or a portion thereof which performs one or more functions. For example, according to an embodiment, the module may be implemented in a form of an application-specific integrated circuit (ASIC).

Various embodiments may be implemented by software (e.g., a program) including one or more instructions stored in a storage medium (e.g., an internal memory or an external memory) readable by a machine (e.g., an electronic device 60). For example, a processor of the machine (e.g., the electronic device 60) may call, among one or more instructions stored in the storage medium, at least one instruction, and may execute the instruction. This allows at least one function to be performed according to the called at least one instruction. The one or more instructions may include a code that is made by a compiler or a code that may be executed by an interpreter. The storage medium that may be read by a device may be provided in a form of a non-transitory storage medium. Here, the 'non-transitory storage medium' means that the storage medium is a tangible device and does not include a signal (e.g., an electromagnetic wave), and with regard to the term, a case, in which data are semi-permanently stored in the storage medium, and a case, in which data are temporarily stored in the storage medium, are not distinguished.

According to an embodiment, methods according to various embodiments may be provided to be included in a computer program product. The computer program product may be traded between a seller and a purchaser. The computer program product may be distributed in a form of a storage medium that may be read by a device (e.g., a compact disk read only memory (CD-ROM)) or may be distributed (e.g., downloaded or uploaded) through an application store or directly or online between two user devices. In the online distribution, at least a portion of the computer program product may be at least temporarily stored in a storage medium, such as a server of a manufacturer, a server of an application store, or a memory of a relay server, which may be read by a device, or temporarily generated.

According to various embodiments, each component or element (e.g., a module or program) of the components or elements described herein may include one or a plurality of entities, and some of the plurality of entities may be disposed to other components with being separated therefrom. According to various embodiments, among the components described herein, one or more components or operations thereof may be omitted or one or more other components or operations thereof may be added to the components. Alternatively or additionally, the plurality of components (e.g., the modules or programs) may be integrated into one component. In this case, the integrated components may perform one or more functions of each component of the plurality of components in a way that they are the same as or similar to the functions performed by the corresponding components among the plurality of components before the integration. According to various embodiments, operations performed by the modules, programs, or other components may be executed sequentially, in parallel, repeatedly, or heuristically, one or more operations may be executed in another sequence or omitted, or one or more other operations may be added thereto.

## Claims

1. A display device, comprising:
a display panel (100) which includes a non-bonding area formed at an end portion thereof;
a first substrate (200) which has a first end portion connected with the end portion of the display panel and a notch (230) formed therein to correspond to the non-bonding area, and includes a driving element (250) configured to control driving of the display panel; and
a second substrate (300) connected with a second end portion of the first substrate,
wherein the display panel (100) comprises a first-1 test pad (111) disposed at a first side of the non-bonding area and a first-2 test pad (112) disposed at a second side of the non-bonding area,
the first substrate (200) comprises a first-1 connection pad (211) bonded with the first-1 test pad (111), a first-2 connection pad (212) bonded with the first-2 test pad (112), a second-1 connection pad (221) connected with the first-1 connection pad (211) through one or more first lines (241), and a second-2 connection pad (222) connected with the first-2 connection pad (212) through one or more second lines (242),
the second substrate (300) comprises a second-1 test pad (311) bonded with the second-1 connection pad (221), a second-2 test pad (312) bonded with the second-2 connection pad (222), a first test point (321) connected with the second-1 test pad (311), and a second test point (322) connected with the second-2 test pad (312), and
a portion of the first lines (241) and a portion of the second lines (242) overlap with the driving element (250).

2. The display device according to claim 1, wherein the non-bonding area comprises:
an area receiving at least one component mounted on an external device to which the display device is mounted; or
an area where a display panel notch (120) is formed so that at least one component mounted on the external device passes therethrough.

3. The display device according to claim 1 or 2, wherein the display panel further comprises a first-3 test pad disposed at the first side of the non-bonding area and a first-4 test pad disposed at the second side of the non-bonding area,
the first substrate further comprises a first-3 connection pad bonded with the first-3 test pad, a first-4 connection pad bonded with the first-4 test pad, a second-3 connection pad connected with the first-3 connection pad through one or more third lines, and a second-4 connection pad connected with the first-4 connection pad through one or more fourth lines, and
the second substrate further comprises a second-3 test pad bonded with the second-3 connection pad, a second-4 test pad bonded with the second-4 connection pad, a third test point connected with the second-3 test pad, and a fourth test point connected with the second-4 test pad.

4. The display device according to claim 3, wherein the first-1 test pad, the first-2 test pad, the first-3 test pad, the first-4 test pad, the first-1 connection pad, the first-2 connection pad, the first-3 connection pad, and the first-4 connection pad each include four pads, respectively,
the second-1 connection pad, the second-2 connection pad, the second-3 connection pad, the second-4 connection pad, the second-1 test pad, the second-2 test pad, the second-3 test pad, and the second-4 test pad each include five pads, respectively, and
the first test point, the second test point, the third test point, and the fourth test point each include six points, respectively.

5. The display device according to any one of the preceding claims, wherein the display panel and the first substrate are bonded in a film on glass (FOG) or film on board (FOB) manner,
the driving element is bonded to the first substrate in a chip on film (COF) manner, and
the first substrate and the second substrate are bonded in a film on film (FOF) manner.

6. The display device according to any one of the preceding claims, wherein the first substrate is formed as a single layer,
the second substrate is formed as a flexible printed circuit board (FPCB), and
wherein a portion of the first lines and a portion of the second lines pass through a lower portion of the driving element.

7. The display device according to any one of the preceding claims, wherein the driving element comprises a first-1 driving pad part, a first-2 driving pad part electrically connected with the first-1 driving pad part, a second-1 driving pad part, and a second-2 driving pad part electrically connected with the second-1 driving pad part,
the first lines comprise a first-1 line which connects the first-1 connection pad with the first-1 driving pad part, and a first-2 line which connects the first-2 driving pad part with the second-1 connection pad, and
the second lines comprise a second-1 line which connects the first-2 connection pad with the second-1 driving pad part, and a second-2 line which connects the second-2 driving pad part with the second-2 connection pad.

8. The display device according to any one of the preceding claims, wherein the second substrate further comprises a fifth test point and a sixth test point which are configured to measure an entire bonding resistance including a first bonding resistance between the display panel and the first substrate, and a second bonding resistance between the first substrate and the second substrate.

9. An electronic device comprising:
a housing; and
a display device mounted in the housing,
wherein the display device comprises:
a display panel which includes a non-bonding area formed at an end portion thereof;
a first substrate which has a first end portion connected with the end portion of the display panel and a notch formed therein to correspond to the non-bonding area, and includes a driving element configured to control driving of the display panel; and
a second substrate connected with a second end portion of the first substrate,
wherein the display panel comprises a first-1 test pad disposed at a first side of the non-bonding area and a first-2 test pad disposed at a second side of the non-bonding area,
the first substrate comprises a first-1 connection pad bonded with the first-1 test pad, a first-2 connection pad bonded with the first-2 test pad, a second-1 connection pad connected with the first-1 connection pad through one or more first lines, and a second-2 connection pad connected with the first-2 connection pad through one or more second lines,
the second substrate comprises a second-1 test pad bonded with the second-1 connection pad, a second-2 test pad bonded with the second-2 connection pad, a first test point connected with the second-1 test pad, and a second test point connected with the second-2 test pad, and
a portion of the first lines and a portion of the second lines overlap with the driving element.

10. The electronic device according to claim 9, wherein the non-bonding area comprises:
an area receiving at least one component mounted on an external device to which the display device is mounted; or
an area where a display panel notch is formed so that at least one component mounted on the external device passes therethrough.

11. The electronic device according to claim 9, wherein the display panel further comprises a first-3 test pad disposed at the first side portion of the display panel and a first-4 test pad disposed at the second side portion of the display panel, wherein the first side portion and the second side portion are separated by the non-bonding area,
the first substrate further comprises a first-3 connection pad bonded with the first-3 test pad, a first-4 connection pad bonded with the first-4 test pad, a second-3 connection pad connected with the first-3 connection pad through one or more third lines, and a second-4 connection pad connected with the first-4 connection pad through one or more fourth lines, and
the second substrate further comprises a second-3 test pad bonded with the second-3 connection pad, a second-4 test pad bonded with the second-4 connection pad, a third test point connected with the second-3 test pad, and a fourth test point connected with the second-4 test pad.

12. The electronic device according to claim 11, wherein the first-1 test pad, the first-2 test pad, the first-3 test pad, the first-4 test pad, the first-1 connection pad, the first-2 connection pad, the first-3 connection pad, and the first-4 connection pad each include four pads, respectively,
the second-1 connection pad, the second-2 connection pad, the second-3 connection pad, the second-4 connection pad, the second-1 test pad, the second-2 test pad, the second-3 test pad, and the second-4 test pad each include five pads, respectively, and
the first test point, the second test point, the third test point, and the fourth test point each include six points, respectively.

13. The electronic device according to claim 9, wherein the first substrate is formed as a single layer,
the second substrate is formed as a flexible printed circuit board (FPCB), and
wherein a portion of the first lines and a portion of the second lines pass through a lower portion of the driving element.

14. The electronic device according to claim 9, wherein the driving element comprises a first-1 driving pad part, a first-2 driving pad part electrically connected with the first-1 driving pad part, a second-1 driving pad part, and a second-2 driving pad part electrically connected with the second-1 driving pad part,
the first lines comprises a first-1 line which connects the first-1 connection pad with the first-1 driving pad part, and a first-2 line which connects the first-2 driving pad part with the second-1 connection pad, and
the second lines comprises a second-1 line which connects the first-2 connection pad with the second-1 driving pad part, and a second-2 line which connects the second-2 driving pad part with the second-2 connection pad.

15. The electronic device according to claim 9, wherein the second substrate further comprises a fifth test point and a sixth test point which are configured to measure an entire bonding resistance including a first bonding resistance between the display panel and the first substrate, and a second bonding resistance between the first substrate and the second substrate.
